# EUROPEAN PATENT SPECIFICATION

(11) **EP 2 693 854 B1**
(45) Date of publication and mention of the grant of the patent: **04.03.2015**
(21) Application number: 13158902.0
(22) Date of filing: 13.03.2013
(51) Int. Cl.: H05K 3/28, G09F 9/33, H01L 33/60, H01L 33/48

(54) **High-contrast waterproof surface-mounted led lamp**
Wasserdichte kontrastreiche oberflächenmontierte LED-Lampe
Lamp à DEL à contraste élevé imperméable, montée en surface

(30) Priority: 02.08.2012 CN 201210272821
(43) Date of publication of application: 05.02.2014
(73) Proprietor: Kindwin Opto Electronic (Shen Zhen) Co. Ltd., Shenzhen, Guangdong 518111 (CN)
(72) Inventor: Ou, Daniel, 518111 Shenzhen (CN)
(74) Representative: Decamps, Alain René François

(56) References cited:
- EP-A1- 1 273 618
- WO-A1-2011/064072
- CN-A- 102 110 764
- CN-U- 201 788 643
- DE-A1- 19 901 916
- DE-A1-102006 046 678
- KR-A- 20050 005 688
- US-A- 5 382 811

## Description

### BACKGROUND

### Technical Field

The present invention relates to a surface-mounted LED lamp, and more particularly to a high-contrast waterproof surface-mounted LED lamp.

### Related Art

The rapid popularity of LED lamps directly leads to the increasing rise of the sales volume and decrease of the cost, which is good for the promotion of display screens of higher contrast and higher resolution. An existing LED lamp generally includes: a plastic casing provided with a reflector cup, a packaged PCB disposed on a rear side of the plastic casing, and an LED chip and an optical guiding molding compound which are electrically connected to the PCB and disposed in the reflector cup.

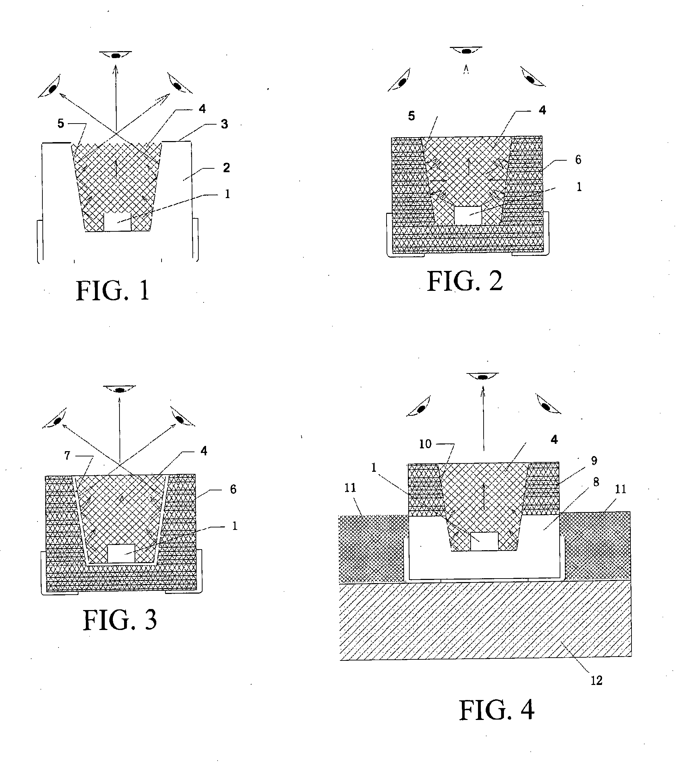

To improve the display contrast, the conventional surface-mounted LED lamp is generally fabricated in the following manners:
1. A white casing screen-printed with a black coating-screen-printing a black coating 3 on a top surface of a white plastic casing 2, so that the surface of a white reflector cup 5 forms chromatic contrast against the black coating 3 on the top surface, thereby increasing the display contrast of the product, an LED chip 1 and an optical guiding molding compound 4 being disposed in the reflector cup 5, as shown in FIG. 1.
   KR 1020050005688-A discloses a display element with LEDS which has a lower light reflection portion and an upper light absorbing portion on the light reflection portion.
   The disadvantage is that: since the four sides of the LED chip 1 and the inner surface of the reflector cup 5 are all white, the white plastic surfaces reflect external light to reduce the display contrast of the product.
2. An all-black casing-using black plastic instead of the original white plastic to form a casing through injection-molding, so that the whole casing 6 and the surface of the reflector cup 5 are both black, thereby increasing the display contrast of the product, as shown in FIG. 2.
   DE 102006046678-A discloses a LED package with a light absorbing portion on an outer surface of a light reflecting portion surrounding the LED.
   The disadvantage is that: since the surface of the reflector cup 5 inside the LED chip 1 is also black, the light emitted by the LED chip cannot be well reflected from the black surface of the reflector cup, which greatly reduces the luminance of the LED. To solve the problem of low luminance, some manufacturers increase the LED current to improve the luminance of the LED, which is against the original intention of using the LED to save power and also increases the heat discharge of the product, thereby reducing the service life of the product.
3. A black-outside and white-inside casing-using black plastic to form a casing 6 through injection-molding, and forming a reflector cup liner 7 with a white material through injection-molding, so that the periphery and the top of the reflector cup liner are both black, and the surface of the reflector cup liner 7 is white, which effectively increases the contrast without reducing the luminance of the LED chip, as shown in FIG. 3.

Such a device is disclosed in WO 2011/064072-A.

The disadvantage is that: the external light is reflected from the surface of the reflector cup, so that the contrast is reduced. Besides, it is difficult for the three-layer combined structure to achieve a desirable waterproof effect. Generally, the manufacturers only apply this casing in a product requiring a low waterproof effect due to its limited applicability.

Therefore, how to design a waterproof surface-mounted LED lamp having a high contrast, low power consumption and high applicability is a technical problem to be urgently solved in this field.

### SUMMARY

To solve the above technical problem, the present invention provides a high-contrast waterproof surface-mounted LED lamp having a high contrast, low power consumption and high applicability.

The high-contrast waterproof surface-mounted LED lamp of the present invention includes: a casing provided with a reflector cup, a PCB disposed on a lower surface of the casing, and an LED chip and an optical guiding molding compound disposed in the reflector cup. The casing is formed by laminating a lower light color layer and an upper dark color layer. Black waterproof sealant is provided on an upper surface of the PCB and an outer surface of the light color layer of the casing.

The light color layer may be a white layer, a light yellow layer or a light gray layer.

The dark color layer may be a black layer, a dark blue layer, a dark gray layer or a dark brown layer.

In the present invention, the casing provided with the reflector cup is formed by laminating the lower light color layer and the upper dark color layer, so that an inner surface of the reflector cup formed by the depression of an upper surface of the casing has a lower light color layer and an upper dark color layer. When the LED chip emits light, the bottom surface and the lower light color surface of the reflector cup reflect the light. The external light is generally only irradiated to the upper dark color surface of the reflector cup (but not reflected), and is difficult to be irradiated to the lower light color surface, so that the external light may not affect the luminance of the LED chip, and the display contrast of the product is enhanced. Moreover, the black waterproof sealant is provided on the upper surface of the PCB and the outer surface of the light color layer of the casing. The sealant completely covers the outer surface of the light color layer of the casing, so that the upper surface and the four sides of the casing are all black, but the white reflective parts at the four sides of the LED and the lower portion of the reflector cup are sophisticatedly reserved, thereby maintaining the optimal effect of the luminance of the LED chip. Since the upper and lower layer joint portions of the casing, and the exposed interlayer wires and bottom layer portion of the LED chip are all completely covered by the waterproof sealant, the waterproof effect is ensured.

### BRIEF DESCRIPTION OF THE DRAWINGS

FIG. 1 is a cross-sectional view of an LED lamp with "a white casing screen-printed with a black coating";
FIG. 2 is a cross-sectional view of an LED lamp with "an all-black casing";
FIG. 3 is a cross-sectional view of an LED lamp with "a black-outside and white-inside casing"; and
FIG. 4 is a cross-sectional view of an LED lamp according to a preferred embodiment of the present invention.

### DETAILED DESCRIPTION

As shown in FIG. 4, the present invention provides an embodiment of a high-contrast waterproof surface-mounted LED lamp, which includes: a plastic casing provided with a reflector cup 10, a PCB 12 disposed on a lower surface of the casing, and an LED chip 1 electrically connected to the PCB and disposed in the reflector cup 10. The reflector cup 10 is filled with an optical guiding molding compound 4. The casing in the present invention is formed by laminating a lower light color layer 8 and an upper dark color layer 9. Black waterproof sealant 11 is provided on an upper surface of the PCB 12 and an outer surface of the light color layer 8 of the casing. In this embodiment, the light color layer 8 is a white layer, and may also be other light color layers according to requirements, for example, a light yellow layer or a light gray layer. The dark color layer 9 is a black layer, and may also be other dark color layers according to requirements, for example, a dark blue layer, a dark gray layer or a dark brown layer.

In the present invention, an inner surface of the reflector cup has a lower light color layer and an upper dark color layer. When the LED chip emits light, the bottom surface and the lower light color surface of the reflector cup reflect the light. The external light is generally only irradiated to the upper dark color surface of the reflector cup (but not reflected), and is difficult to be irradiated to the lower light color surface, so that the external light may not affect the luminance of the LED chip, and the display contrast of the product is enhanced. The black waterproof sealant is provided to make the appearance of the casing all black, thereby maintaining the optimal effect of the luminance of the LED chip. Since the upper and lower layer joint portions of the casing, and the exposed interlayer wires and bottom layer portion of the LED chip are all completely covered by the waterproof sealant, the waterproof effect is ensured.

The structure of the present invention is described above with exemplary embodiments. It should be noted that, persons of ordinary skill in the art can make some modifications and variations without departing from the scope of the present invention as defined by the appended claims, and the modifications and variations also fall within the scope of the invention.

## Claims

1. A high-contrast waterproof surface-mounted LED lamp, comprising: a casing provided with a reflector cup (10), a PCB (12) disposed on a lower surface of the casing, a LED chip (1) and an optical guiding molding compound (4) disposed in the reflector cup (10), wherein the casing is formed by laminating a lower light color layer (8) and an upper dark color layer (9), a black waterproof sealant (11) being provided on the upper surface of the PCB (12) and the outer surface of the light color layer (8) of the casing.

2. The high-contrast waterproof surface-mounted LED lamp according to claim 1, **characterized in that** the light color layer (8) is a white layer, a light yellow layer or a light gray layer.

3. The high-contrast waterproof surface-mounted LED lamp according to any preceding claim, **characterized in that** the dark color layer (9) is a black layer, a dark blue layer, a dark gray layer or a dark brown layer.

## Patentansprüche

1. Eine kontrastreiche, wasserdichte LED-Aufbauleuchte bestehend aus einem Gehäuse mit einer Reflektorwanne (10), einer Leiterplatte (12), die an einer unteren Oberfläche des Gehäuses angebracht ist, einem LED-Chip (1) und einer in der Reflektorwanne angebrachten Formmasse für die optische Führung (4), wobei das Gehäuse durch Laminieren einer unteren hellfärbigen Schicht (8) und einer oberen dunkelfärbigen Schicht (9) gebildet wird, einem schwarzen, wasserfesten (11) Dichtmittel, das auf der Oberseite der Leiterplatte (12) und der Außenseite der hellfärbigen Schicht (8) des Gehäuses aufgebracht ist.

2. Die kontrastreiche wasserdichte LED-Aufbauleuchte nach Anspruch 1 ist **dadurch gekennzeichnet, dass** die hellfärbige Schicht (8) eine weiße Schicht, eine hellgelbe Schicht oder eine hellgraue Schicht ist.

3. Die kontrastreiche, wasserdichte LED-Aufbauleuchte nach einem der obigen Ansprüche ist **dadurch gekennzeichnet, dass** die dunkelfärbige Schicht (9) eine schwarze Schicht, eine dunkelgraue Schicht oder eine dunkelblaue Schicht ist.

## Revendications

1. Lampe DEL montée en surface, étanche, à contraste élevé, comprenant : une enveloppe munie d'une coupelle formant réflecteur (10), d'une PCB (12) disposée sur une surface inférieure de l'enveloppe, d'une puce DEL (1) et d'un composé de moulage pour guidage optique (4) disposé dans la coupelle formant réflecteur (10), dans laquelle l'enveloppe est formée en stratifiant une couche inférieure de couleur claire (8) et une couche supérieure de couleur sombre (9), un agent d'étanchéité imperméable noir (11) étant disposé sur la surface supérieure de la PCB (12) et la surface extérieure de la couche de couleur claire (8) de l'enveloppe.

2. Lampe DEL montée en surface, étanche, à contraste élevé, selon la revendication 1, **caractérisée en ce que** la couche de couleur claire (8) est une couche blanche, une couche jaune clair ou une couche gris clair.

3. Lampe DEL montée en surface, étanche, à contraste élevé, selon l'une quelconque des revendications précédentes, **caractérisée en ce que** la couche de couleur sombre (9) est une couche noire, une couche bleu foncé, une couche gris foncé ou une couche brun foncé.
